# EUROPEAN PATENT APPLICATION

(11) **EP 3 404 830 A1**
(43) Date of publication of application: **21.11.2018**
(21) Application number: 16891400.0
(22) Date of filing: 22.02.2016
(51) Int. Cl.: H03F 3/04

(54) **OUTPUT CIRCUIT OF AMPLIFIER**

(71) Applicant: Akaishi, Takeshi, Tokyo 112-0004 (JP)
(72) Inventor: Akaishi, Takeshi, Tokyo 112-0004 (JP)
(74) Representative: Prüfer & Partner mbB Patentanwälte · Rechtsanwälte
(86) International application number: PCT/JP2016/055105
(87) International publication number: WO 2017/145241

(57) **Abstract**

Provided is an output circuit of an amplifier, said output circuit not changing power consumption. Since the output circuit of the amplifier does not flow, to a power supply circuit, a current correlated to a signal, the output circuit is not affected by the power supply circuit. The output circuit of the amplifier is provided with: a three-terminal amplifying element having an input terminal, an output terminal, and a common terminal; and a constant current circuit, which is connected to the common terminal, and which flows a substantially constant current to the three-terminal amplifying element. The output terminal is grounded, and amplified output is taken out between the output terminal, and a contact point between the common terminal and the constant current circuit. Since the consumption current of the output circuit of the amplifier is merely a current flowing in the constant current circuit, there is no consumption current change correlated to the output current.

## Description

### FIELD OF INVENTION

The present invention relates to an output circuit of an amplifier for amplifying acoustic signals, particularly to an output circuit of an analog signal amplifier, wherein the consumption current stays nearly constant.

### BACKGROUND OF INVENTION

In the field of output circuits for analog signal amplifiers, the power source circuit has a great influence on sound quality. It is widely believed that preventing flow of signal current into the power source circuit is important.

### (Non-patent document 1)

In an emitter follower circuit, which is a common output circuit, the consumption current changes similarly to the output current and flows into the power source of the circuit. In a two power-sourced complementary emitter follower circuit having a positive and a negative power supply, which is widely used in audio power amplifiers, the consumption current changes in a further complicated way in correlation to the output current.

Among researches on power source circuits, some in the field of specific amplifier circuits have aimed at improving sound quality by keeping the consumption current constant, but no continuing studies have been made. (Non-patent document 2)

### PRIOR ART

### PATENT DOCUMENT

Patent Document 1: Japanese Patent No. 4965506 Publication

### NON-PATENT DOCUMENT

Non-Patent Document 1: Rajio Gijutsusha, Rajio Gijutsu 1988.12, p.75 "Making an MC head amp with cross talk cancel circuit ACT-2" Takaomi Iino
Non-Patent Document 2: IA Shuppan, Rajio Gijutsu 2013.6, p.57 "Amp camp for amp making beginners: Making an amp #1" Nelson Pass (translated by Yoshimitsu Nakamura)
Non-Patent Document 3: IA Shuppan, Radio Gijutsu 2015.12, p.101 "Enjoying triode-like V-FET sound 2SK82/2SJ28: Grade A PP amp" Nelson Pass (translated by Yoshimitsu Nakamura)

### SUMMARY OF INVENTION

### PROBLEMS TO BE SOLVED BY INVENTION

In a conventional analog amplifier for audio use, the consumption current of the output circuit changed in correlation with the output signal. This change was unavoidable.

The present invention aims at providing an amplifier output circuit wherein the consumption current does not change, by preventing the signal-correlated current from flowing into the power source circuit.

### MEANS OF SOLVING THE PROBLEMS

According to the present invention, an output circuit of an amplifier comprises a three-terminal amplifier element having an input terminal, an output terminal (collector, drain), and a common terminal (emitter, source), and a constant current circuit connected to said common terminal and supplying approximately a constant current to said three-terminal amplifier element, characterized in that said output terminal is grounded, and an amplified output is taken out from between a connection point of the common terminal with the constant current circuit, and the ground. As the consumption current of the amplifier output circuit according to the present invention is solely the current flowing in the constant current circuit, there is no change in the consumption current in correlation with the output current. The amplifier output circuit according to the present invention is a constant consumption current output circuit (CCC output circuit).

### BRIEF DESCRIPTION OF DRAWINGS

[FIG. 1] Fig. 1 is a circuit diagram according to Embodiment 1 of the present invention.
[FIG. 2] Fig. 2 is a circuit diagram according to Embodiment 2 of the present invention.
[FIG. 3] Fig. 3 is a circuit diagram according to Embodiment 3 of the present invention.

### MODE OF WORKING THE INVENTION

The present invention has fulfilled the aim of keeping the consumption current constant while using the least number of components.

### EMBODIMENT 1

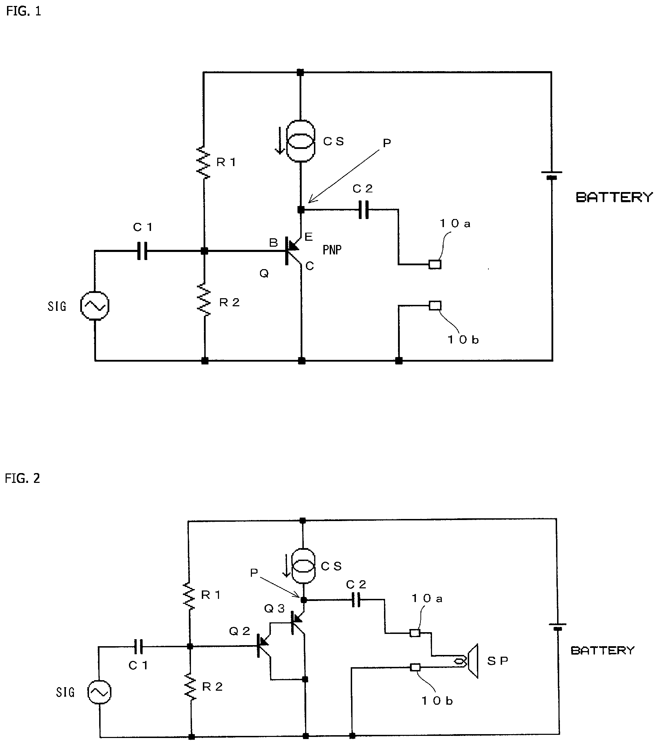

Fig. 1 shows a circuit diagram of an amplifier output circuit according to Embodiment 1.
A transistor Q (three-terminal amplifier element) comprises a base B (input terminal), a collector C (output terminal) and an emitter E (common terminal) . A constant current circuit CS is connected with emitter E of transistor Q. This connection point P is further connected with an amplifier output terminal 10a. Collector C is grounded.

The signal of a signal source SIG is amplified through transistor Q. The amplified signal appears between amplifier output terminals 10a and 10b. Amplifier output terminal 10b is grounded. A condenser C2 for cutting off direct current may be provided between connection point P and amplifier output terminal 10a.

Condenser C1 cuts off the direct current of signal source SIG. Resistance R1 and R2 form a bias circuit.

In Embodiment 1, the constant current circuit CS is connected with emitter E of transistor Q, so that the consumption current of transistor Q remains unchanged. By applying Embodiment 1 to audio preamplifiers, etc., it is possible to form an output portion that does not allow signal-correlated current to flow into the power source circuit.

Furthermore, in a preliminary amplifying portion (not illustrated), it is possible to similarly connect the constant current circuit S with the emitter of the transistor, thereby selecting a circuit wherein the signal causes no change in the consumption current. As result, such amplifying portion and such output portion as a whole can form a preamplifier, etc., wherein signal-correlated current does not flow into the power source circuit.

### EMBODIMENT 2

Fig. 2 shows a circuit diagram of an amplifier output circuit according to Embodiment 2.
Transistors Q2 and Q3 are Darlington transistors. Constant current circuit DS is connected with the emitter of the subsequent transistor Q3. The connection point P is connected with amplifier output terminal 10a. Amplifier output terminals 10a and 10b are connected to a speaker SP.

By connecting the output transistors in Darlington connection, etc., it is possible to gain a large output current, thereby forming an output portion of an audio power amplifier, wherein signal-correlated current does not flow into the power source circuit.

Furthermore, in a preliminary amplifying portion (not illustrated), it is possible to similarly connect the constant current circuit S with the emitter of the transistor, thereby selecting a circuit wherein the signal causes no change in the consumption current. As result, such amplifying portion and such output portion as a whole can form a power amplifier, etc. , wherein signal-correlated current does not flow into the power source circuit.

### EMBODIMENT 3

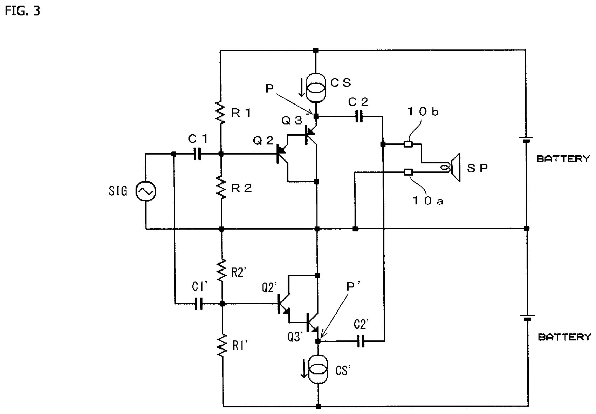

Fig. 3 shows a circuit diagram of an amplifier output circuit according to Embodiment 3.

Embodiment 3 is an application of Embodiment 2 to a complementary output circuit. The complementary circuit comprises PNP (first polarization) transistors Q2 and Q3, and NPN (second polarization) transistors Q2' and Q3'.

In the complementary output circuit, transistors Q2 and Q3, and transistors Q2' and Q3' are in Darlington connection. Constant current circuits CS and CS' are connected with the emitter of the subsequent transistors Q3 and Q3' . The amplifier output terminal 10a is connected with the connection points P and P'.

The current amplification factor of the transmitter has current dependency, which causes a distortion in the output signal. By combining PNP and NPN output transistors to form the complementary output circuit, it is possible to cancel the curvature property of the current dependency, thereby gaining an output signal with less distortion. The complementary output circuit can be structured so that signal-correlated current does not flow into the power source circuit.

In Figs. 1 to 3, PNP and/or NPN bipolar transistors or Darlington connected transistors are used as the three-terminal amplifier elements. Instead of these, or together with these, it is also possible to use an FET and/or a vacuum tube.

The current supplied by the power source is solely the current defined by the constant current circuit, so the consumption current does not change according to the sound output, and the power source circuit does not affect the sound quality.

According to an embodiment of the present invention, it can be said that the reaction of the sound output flowing on the load is cancelled by the constant current source, thereby preventing the current correlated to the sound signal from flowing into the power source circuit.

According to an embodiment of the present invention, it is possible to prevent the power source circuit from affecting sound quality, as current correlated to the sound signal does not flow into the power source circuit. As result, sound can be achieved that has higher quality than ever before. Also, it is possible to prevent the sound output from affecting the power supply line.

According to an embodiment of the present invention, the consumption current is constant regardless of the size of the input signal, so when there is no or little input signal, the current is large, in other words, the idling current is large. This is especially notable in the case of power amplifiers.

When the maximum output current is +/-1(A), the idling current need only be 0(A) in the case of an output circuit of a Class B complementary emitter follower amplifier, and the idling current need only be 1(A) in the case of an output circuit of a Class A complementary emitter follower amplifier. However, in the output circuit of an amplifier according to the embodiment of the present invention, the idling current becomes twice the current of 1(A), requiring twice the idling current of that of the output circuit of a Class A complementary emitter follower amplifier.

The circuit in Non-Patent Document 2 is a source grounded circuit, which is different from the drain grounded circuit or the collector grounded circuit according to an embodiment of the present invention.

The circuit in Non-Patent Document 3 is a conventional complementary common drain (source follower), which is completely different from the circuit according to an embodiment of the present invention.

### DESCRIPTION OF REFERENCE NUMERALS

B transistor base (input terminal)
C transistor collector (output terminal)
E transistor emitter (common terminal)
CS, CS' power source
Q1 to Q3 transistor (three-terminal amplifier element) SIG signal source
10a, 10b amplified output end

## Claims

1. An output circuit of an amplifier, comprising a three-terminal amplifier element having an input terminal, an output terminal, and a common terminal; and
a constant current circuit connected to said common terminal and supplying approximately a constant current to said three-terminal amplifier element, **characterized in that** said output terminal is grounded, and
an amplified output is taken out from between a connection point of the common terminal with the constant current circuit, and the ground.

2. An output circuit of an amplifier according to Claim 1, **characterized in that** said three-terminal amplifier element is an element wherein a plurality of three-terminal amplifier elements are Darlington connected.

3. An output circuit of an amplifier including a complementary circuit comprising a first polarized three-terminal amplifier element and a second polarized three-terminal amplifier element, **characterized in** comprising:
a first constant current circuit connected to a common terminal of said first polarized three-terminal amplifier element and supplying an approximately constant current to said first polarized three-terminal amplifier element; and
a second constant current circuit connected to a common terminal of said second polarized three-terminal amplifier element and supplying an approximately constant current to said second polarized three-terminal amplifier element; wherein
the output terminals of said first polarized and said second polarized three-terminal amplifier elements are respectively grounded,
the common terminals of said first polarized and said second polarized three-terminal amplifier elements are respectively connected to an amplified output end, and
an amplified output is taken out from between said amplified output end and the ground.
